# EUROPEAN PATENT APPLICATION

(11) **EP 4 708 355 A1**
(43) Date of publication of application: **11.03.2026**
(21) Application number: 24842325.3
(22) Date of filing: 12.07.2024
(51) Int. Cl.: H01L 21/677

(54) **WAFER TRANSFER DEVICE AND SEMICONDUCTOR INSPECTION APPARATUS**

(30) Priority: 14.07.2023 CN 202310868500
(71) Applicant: Zhongke Jingyuan Electron Limited, Beijing (CN), Beijing 100176 (CN)
(72) Inventor: MI, Tao, Beijing 100176 (CN); HAN, Chunying, Beijing 100176 (CN)
(74) Representative: Boult Wade Tennant LLP
(86) International application number: PCT/CN2024/105307
(87) International publication number: WO 2025/016332

(57) **Abstract**

The present application belongs to the technical field of handling devices, and specifically relates to a wafer transfer device and a semiconductor inspection apparatus. The wafer transfer device comprises a valve plate pipeline, a transmission mechanism and a carrier seat, wherein the valve plate pipeline comprises a valve plate and a pipeline extending from the valve plate in a first direction; the carrier seat is connected to the valve plate and, in the first direction, located on the side of the valve plate away from the transmission mechanism; and the transmission mechanism is connected to the pipeline, and the transmission mechanism is configured to be capable of driving the valve plate pipeline to move in the first direction, so as to adjust the positions of the valve plate and the carrier seat in the first direction. By means of the transmission mechanism driving the valve plate pipeline to move in the first direction, the position of the valve plate in the first direction is shifted, allowing two cavities to switch between a disconnected state and a connected state. In addition, the carrier seat for placing a silicon wafer is arranged on the valve plate; when the valve plate moves in the first direction in order to switch the state of the two cavities, the valve plate is integrated with the carrier seat thus synchronously handling the silicon wafer.

## Description

### TECHNICAL FIELD

The present disclosure belongs to the technical field of handling tool, and particularly relates to a wafer transfer apparatus and a semiconductor inspection device.

### BACKGROUND

The existing semiconductor inspection device includes a loadlock chamber and a main vacuum chamber. A stage configured to carry a silicon wafer is provided in the loadlock chamber. A process platform and a handling robot is provided in the main vacuum chamber. A gate valve is arranged between the loadlock chamber and the main vacuum chamber and configured to communicate or isolate the loadlock chamber and the main vacuum chamber.

In the existing wafer transfer process, a silicon wafer on the atmosphere side is first disposed in the loadlock chamber, and then the loadlock chamber is evacuated. In a condition that a vacuum level of the loadlock chamber satisfies an opening condition of the gate valve, the gate valve is opened, and the handling robot in the main vacuum chamber operates to transfer the silicon wafer in the loadlock chamber to the process platform.

At present, this wafer transfer process involves cumbersome operations and is inefficient.

### SUMMARY

The present disclosure provides a wafer transfer apparatus and a semiconductor inspection device to solve the technical problems of the cumbersome and inefficient wafer transfer process mentioned in the prior art.

In an aspect, a wafer transfer apparatus is provided. The wafer transfer apparatus includes a valve plate piping, a drive mechanism, and a stage. The valve plate piping includes a valve plate and a piping extending from the valve plate in a first direction. The stage is connected to the valve plate and is located on a side of the valve plate away from the drive mechanism in the first direction. The drive mechanism is connected to the piping, and is configured to drive the valve plate piping to move in the first direction to adjust a position of the valve plate and a position of the stage in the first direction.

In some optional embodiments of the present disclosure, the drive mechanism includes a base, a direction-switching limit mechanism, and a power component. The piping passes through the base, the direction-switching limit mechanism is movably connected to the base and the piping, and the power component is disposed on the base and connected to the direction-switching limit mechanism. The power component is configured to drive the direction-switching limit mechanism to operate in a second direction to adjust the position of the valve plate piping in the first direction, and the first direction is perpendicular to the second direction.

In some optional embodiments of the present disclosure, the direction-switching limit mechanism includes a guide seat and a rolling element. The guide seat is provided with a guide groove and is connected to the power component, and the rolling element is connected to the piping and is disposed in the guide groove. The power component is configured to drive the guide seat to move in the second direction so that the rolling element moves in the first direction under guidance of the guide groove.

In some optional embodiments of the present disclosure, the guide groove includes a plurality of horizontal groove sections and a plurality of inclined groove sections. The plurality of horizontal groove sections each extend in the second direction, each of the plurality of inclined groove sections connects adjacent two of the plurality of horizontal groove sections, and the adjacent two of the plurality of horizontal groove sections are spaced apart from each other in the first direction. The power component is configured to drive the guide seat to move in the second direction so that the rolling element switches between the plurality of horizontal groove sections under guidance of a corresponding one of the plurality of inclined groove sections.

In some optional embodiments of the present disclosure, the plurality of horizontal groove sections include a first horizontal groove section, a second horizontal groove section, and a third horizontal groove section that are sequentially spaced apart from each other in the first direction from top to bottom. When the rolling element is located in the first horizontal groove section, the valve plate and the stage are at a first position in the first direction. When the rolling element is located in the second horizontal groove section, the valve plate and the stage are at a second position in the first direction. When the rolling element is located in the third horizontal groove section, the valve plate and the stage are at a third position in the first direction.

In some optional embodiments of the present disclosure, the wafer transfer apparatus includes a sealing assembly. The sealing assembly includes a first deformable sleeve and a sealing support member. The sealing support member is parallel to and spaced apart from the valve plate in the first direction and is located between the valve plate and the drive mechanism. The first deformable sleeve has two ends respectively connected to the valve plate and the sealing support member to enclose and define a third chamber. The piping passes through the third chamber and the sealing support member and protrudes out of the third chamber.

In another aspect, the present disclosure provides a semiconductor inspection device. The semiconductor inspection device includes a first chamber, a second chamber, and the above-described wafer transfer apparatus. The first chamber is connected to the second chamber in the first direction, and the drive mechanism is located outside the second chamber and is located at a side of the second chamber away from the first chamber in the first direction. The valve plate is located in the second chamber, the piping is in communication with the first chamber, and the valve plate is configured to move under an action of the drive mechanism so that the first chamber and the second chamber are in communication with or isolate from each other. Under a condition that the first chamber and the second chamber are in an isolated state, the stage is located in the first chamber, and under a condition that the first chamber and the second chamber are in a communicated state, the stage is located in the second chamber.

In some optional embodiments of the present disclosure, the semiconductor inspection device further includes a vacuum pumping module and a pressure relief module. The vacuum pumping module is disposed at a side of the drive mechanism away from the second chamber in the first direction, is in communication with the piping, and is configured to evacuate the first chamber through the piping. The pressure relief module is connected to the first chamber, is located at a side of the first chamber away from the second chamber in the first direction, and is configured to depressurize the first chamber.

In some optional embodiments of the present disclosure, the pressure relief module includes a cover plate and a pressure relief valve. The cover plate covers the first chamber and is provided with an air passage penetrating through the cover plate. The air passage includes a main air passage section and a plurality of branch air passage sections. The pressure relief valve is in communication with the main air passage section, the main air passage section extends in the first direction, and the plurality of branch air passage sections is arranged symmetrically about a center of the main air passage section and each is connected to the main air passage section and the first chamber.

In some optional embodiments of the present disclosure, the vacuum pumping module includes a first pump, a second pump, a first valve, and a transition piping assembly. The transition piping assembly is connected to the piping, and the first pump and the second pump each are connected to the transition piping assembly and configured to evacuate the first chamber. The first valve is connected to the transition piping assembly, is located upstream of the second pump, and is configured to control the second pump to operate. The first pump is located upstream of the first valve.

In summary, the wafer transfer apparatus and the semiconductor inspection device provided in the present disclosure have at least the following beneficial effects.

According to the wafer transfer apparatus provided in the present disclosure, the valve plate piping is driven by the drive mechanism to move in the first direction, thereby changing the position of the valve plate in the first direction, and thus achieving switching the first chamber and the second chamber between the isolated state and the communicated state. Furthermore, the stage for carrying the silicon wafer is disposed on the valve plate, and thus can move in the first direction together with the valve plate to enter the first chamber or the second chamber. During the movement of the valve plate in the first direction to switch the states of two chambers, since the valve plate synchronously transfers the silicon wafer due to being integrated with the stage. It can be seen that the valve plate not only realizes switching the two chambers between the communicated state and the isolated state, but also can transfer the silicon wafer, thereby greatly shortening the transfer process and improving efficiency.

### BRIEF DESCRIPTION OF THE DRAWINGS

In order to more clearly explain the technical solutions in the specific embodiments of the present disclosure or the prior art, the accompanying drawings for the specific embodiments of the present disclosure or the prior art will be briefly introduced below. Obviously, the drawings described below are merely some embodiments of the present disclosure, and other drawings may be obtained by those with ordinary skill in the art from the drawings without any creative efforts.
FIG. 1 is a partial schematic diagram of a semiconductor inspection device according to an embodiment of the present disclosure;
FIG. 2 is a schematic diagram of a wafer transfer apparatus shown in FIG. 1;
FIG. 3 is a schematic diagram of a cooperation between a vacuum pumping module and a valve plate piping shown in FIG. 1;
FIG. 4 is a schematic diagram of a guide seat according to an embodiment of the present disclosure;
FIG. 5 is a schematic diagram of the guide seat shown in FIG. 4 from another viewing angle; and
FIG. 6 is a cross-sectional view of a cover plate shown in FIG. 1.

### Reference signs:

100, Wafer transfer apparatus;
10, Valve plate piping; 11, Valve plate; 12, Pipe;
20, Drive mechanism; 21, Base; 22, Direction-switching limit mechanism; 221, Guide seat; 222, Rolling element; 23, Power component; 24, Guide mechanism;
30, Stage;
40, Sealing assembly; 41, First deformable sleeve; 42, Sealing support member;
50, Sealing ring;
200, Vacuum pumping module; 201, First pump; 202, Second pump; 203, First valve; 204, Transition piping assembly; 2041, Transition piping section; 2042, Second deformable sleeve; 205, Pressure gauge; 206, Vacuum gauge;
300, Pressure relief module; 301, Cover plate; 302, Pressure relief valve;
400, Handling tool; 500, Second valve; 600, Silicon wafer;
A, Guide groove; A1, Horizontal groove section; A11, First horizontal groove section; A12, Second horizontal groove section; A13, Third horizontal groove section; A2, Inclined groove section; B, Air passage; B1, Main air passage section; B2, Branch air passage section; R1, First chamber; R2, Second chamber; R3, Third chamber.

### DETAILED DESCRIPTION

In the description of the present disclosure, it is to be understood that, unless otherwise specifically stated, terms indicating orientations or positional relationships such as "center", "longitudinal", "lateral", "length", "width", "thickness", "upper", "lower", "front", "back", "left", "right", "vertical", "horizontal", "top", "bottom", "inner", "outer", "clockwise", "counterclockwise", "axial", "radial", and "circumferential" are understood based on the orientations or the positional relationships shown in the drawings, which are merely to facilitate and simplify the description of the present disclosure, rather than to indicate or imply that the referenced apparatuses or elements must have a particular orientation, or be constructed and operated in a particular orientation. Accordingly, no limitations are intended to the present disclosure.

Further, features defined with "first" or "second" are for descriptive purposes only and cannot be understood as indicating or implying relative importance or implicitly indicating the number of technical features indicated. Thus, a feature defined with "first" or "second" may explicitly or implicitly include at least one defined feature. If "a plurality of" appears, its general meaning is at least two, such as two or three, unless otherwise explicitly and specifically defined.

In the present disclosure, unless otherwise explicitly specified and defined, terms such as "installed", "connected", "connection", "fixed" should be understood broadly. For example, it can be a fixed connection, or a detachable connection, or formed into one piece; it can be a mechanical connection or an electrical connection; it can be a direct connection or an indirect connection through an intermediate medium, and can be the internal communication of two elements or the interaction of two elements. For those of ordinary skill in the art, the specific meanings of the above-mentioned terms in the present disclosure can be understood in accordance with specific conditions.

In the description of the specification, the term such as "an embodiment", "some embodiments", "an example", "a specific example", or "some examples" means that a specific feature, structure, material, or characteristic described in combination with the embodiment or example is included in at least one embodiment or example of the present disclosure. In this specification, the schematic expressions of the above terms do not necessarily refer to the same embodiment or example. Furthermore, the specific feature, structure, material, or characteristic described can be combined in any suitable manner in any one or more embodiments or examples. Furthermore, those skilled in the art can combine or group different embodiments or examples as well as features of different embodiments or examples under a condition that they are not in contradiction with each other.

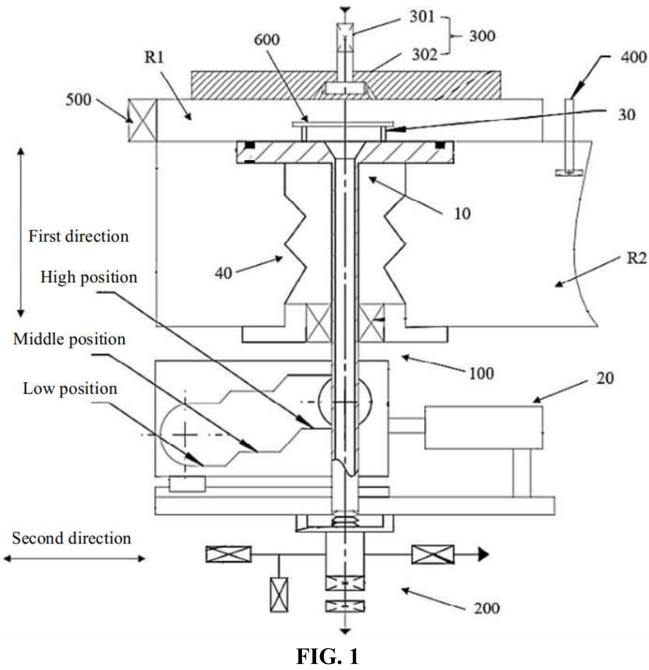

FIG. 1 is a partial schematic diagram of a semiconductor inspection device according to an embodiment of the present disclosure, and FIG. 1 shows the structure of the semiconductor inspection device related to silicon wafer transfer. Referring to FIG. 1, the semiconductor inspection device includes a first chamber R1, a second chamber R2, and a wafer transfer apparatus 100. The wafer transfer apparatus 100 includes a valve plate piping 10, a drive mechanism 20, and a stage 30.

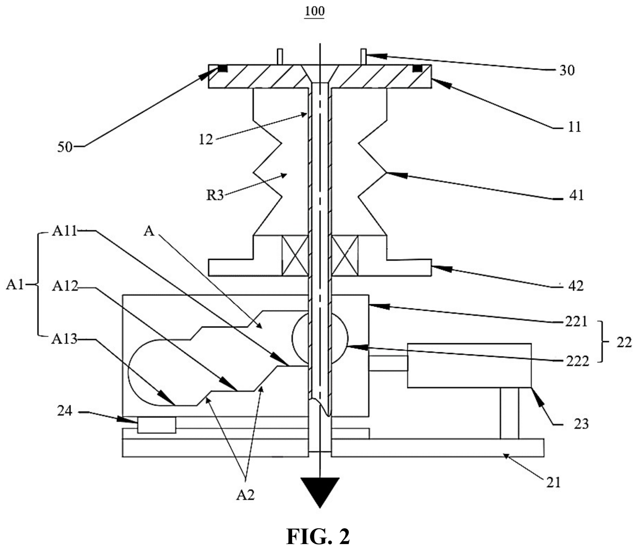

FIG. 2 is a schematic diagram of the wafer transfer apparatus 100 shown in FIG. 1. Referring to FIG. 2, the valve plate piping 10 includes a valve plate 11 and a pipe 12. The valve plate 11 is located in the second chamber R2. The pipe 12 is in communication with the first chamber R1, extends from the valve plate 11 in a first direction, and protrudes out of the second chamber R2 to be connected to the drive mechanism 20. The drive mechanism 20 is located outside the second chamber R2 and at a side of the second chamber R2 away from the first chamber R1 in the first direction.

The drive mechanism 20 is configured to drive the valve plate piping 10 to move in the first direction, so as to adjust a position of the valve plate 11 in the first direction, thereby communicating the first chamber R1 with the second chamber R2 or isolating the first chamber R1 from the second chamber R2. In other words, the valve plate 11 is configured to switch the first chamber R1 and the second chamber R2 between an isolated state and a communicated state. In the isolated state, the first chamber R1 and the second chamber R2 are independently sealed from each other; in the communicated state, the first chamber R1 is in communication with the second chamber R2.

The stage 30 is connected to the valve plate 11 and is located on a side of the valve plate 11 away from the drive mechanism 20 in the first direction, and thus can also move together with the valve plate 11 in the first direction to change its position. Under a condition that the first chamber R1 and the second chamber R2 are in the isolated state, the stage 30 is located in the first chamber R1. Under a condition that the first chamber R1 and the second chamber R2 are in the communicated state, the stage 30 is located in the second chamber R2.

In this embodiment, the stage 30 can carry a silicon wafer 600. The stage 30 is not fixedly installed in the first chamber R1, but is installed on the valve plate 11, and moves from the first chamber R1 into the second chamber R2 under the action of the drive mechanism 20 together with the valve plate 11 for subsequent process treatment. It can be seen that the valve plate 11 in the wafer transfer apparatus 100 is not only limited to communicating the first chamber R1 with the second chamber R2 or isolating the first chamber R1 from the second chamber R2, but also plays a role in driving the stage 30 to transfer the silicon wafer 600 into the second chamber R2. In other words, during the movement of the valve plate 11 in the first direction to switch states, the valve plate 11 is integrated with the stage 30 to synchronously transfer the silicon wafer 600. That is, the valve plate 11 also has a silicon wafer transfer function, which greatly shortens the transfer process and improves efficiency.

It should be understood that a passage is provided between the first chamber R1 and the second chamber R2 for communicating the first chamber R1 with the second chamber R2, and the valve plate 11 is configured to open and close this passage to communicate the first chamber R1 with the second chamber R2 or isolate the first chamber R1 from the second chamber R2. To ensure sealing performance, a sealing ring 50 is provided on a surface of the valve plate 11 close to the stage 30.

In some optional embodiments, the drive mechanism 20 includes a base 21, a direction-switching limit mechanism 22, and a power component 23. The pipe 12 passes through the base 21. The direction-switching limit mechanism 22 is movably connected to the base 21 and the pipe 12. The power component 23 is disposed on the base 21 and connected to the direction-switching limit mechanism 22. The power component 23 is configured to drive the direction-switching limit mechanism 22 to operate in a second direction, so as to adjust a position of the valve plate piping 10 in the first direction. The first direction is perpendicular to the second direction.

In this embodiment, the base 21 is fixed, the direction-switching limit mechanism 22 is movably connected to the base 21, the direction-switching limit mechanism 22 operates in the second direction under the action of the power component 23, the valve plate piping 10 is movably connected to the direction-switching limit mechanism 22, and the direction-switching limit mechanism 22 can drive the valve plate piping 10 to move in the first direction, that is, the direction-switching limit mechanism 22 operates in the second direction relative to the base 21, to drive the valve plate piping 10 to move in the first direction relative to the base 21, thereby changing a position of the valve plate piping 10 in the first direction, i.e., the position of the valve plate 11, thus switching the first chamber R1 and the second chamber R2 between the communicated state and the isolated state.

It can be seen that the direction-switching limit mechanism 22 converts a freedom degree of movement in the second direction provided by the power component 23 into a freedom degree of movement for the valve plate piping 10 in the first direction. It should be noted that, in the embodiments shown in FIGS. 1 and 2, the first direction is the vertical direction, the second direction is the horizontal direction, the first chamber R1 is located above the second chamber R2, and the drive mechanism 20 is located below the second chamber R2. Under the action of the power component 23, the direction-switching limit mechanism 22 can operate in the horizontal direction, thereby causing the valve plate 11 to move vertically.

In some optional embodiments, the wafer transfer apparatus 100 includes a sealing assembly 40. The sealing assembly 40 includes a first deformable sleeve 41 and a sealing support member 42. The sealing support member 42 is parallel to and spaced apart from the valve plate 11 in the first direction and is located between the valve plate 11 and the drive mechanism 20. Two ends of the first deformable sleeve 41 are connected to the valve plate 11 and the sealing support member 42, respectively, and they enclose and define a third chamber R3. The pipe 12 passes through the third chamber R3 and the sealing support member 42 and protrudes out of the third chamber R3.

In this embodiment, the valve plate 11 is located in the second chamber R2, and the sealing support member 42 is installed on a bottom wall of the second chamber R2. Therefore, the first deformable sleeve 41 connected between the valve plate 11 and the sealing support member 42 is located in the second chamber R2 and extends in the first direction. Correspondingly, the third chamber R3 enclosed and defined by the valve plate 11, the first deformable sleeve 41, and the sealing support member 42 is also located in the second chamber R2. The third chamber R3 isolates the second chamber R2 from the external atmosphere.

It should be noted that, to ensure the sealing performance of the second chamber R2, there are certain requirements for the installation levelness of the sealing support member 42 and the valve plate 11 relative to the second chamber R2. In this embodiment, the sealing support member 42 and the valve plate 11 are independent of each other. When installed, the sealing support member 42 and the valve plate 11 are decoupled from each other during leveling adjustments, reducing the difficulty of sealing the second chamber R2 and facilitating maintenance.

As mentioned previously, the pipe 12 extends in the first direction, and the first deformable sleeve 41 also extends in the first direction. Since the pipe 12 passes through the third chamber R3, the first deformable sleeve 41 sleeves the pipe 12.

It should be understood that during the movement of the valve plate 11 in the first direction, the first deformable sleeve 41 deforms to adapt to the position of the valve plate 11 in the first direction. In specific applications, the first deformable sleeve 41 is a bellows arranged along the first direction, and thus can deform in the first direction to adapt to the positional change of the valve plate 11. Of course, the first deformable sleeve 41 is not limited to this. For example, the first deformable sleeve 41 can be an elastic rubber tube.

In specific applications, the sealing support member 42 can be formed by coaxially assembling a bearing seat and a linear bearing. The pipe 12 passes through the linear bearing to protrude out of the third chamber R3. The linear bearing ensures the smoothness of the movement of the pipe 12 in the first direction. Of course, the sealing support member 42 is not limited to this. For example, the sealing support member 42 can be a flange structure with a through hole provided at a center of the flange structure, and the pipe 12 is in clearance fit with the flange structure to ensure the freedom degree of movement of the pipe 12 in the first direction.

It should be understood that relative movement between the pipe 12 and the sealing support member 42 generates debris, which is contained in the third chamber R3, thereby preventing the debris from contaminating the second chamber R2.

In some optional embodiments, the direction-switching limit mechanism 22 includes a guide seat 221 and a rolling element 222. The guide seat 221 is provided with a guide groove A and is connected to the power component 23. The rolling element 222 is connected to the pipe 12 and is disposed in the guide groove A. The power component 23 is configured to drive the guide seat 221 to move in the second direction, thereby causing the rolling element 222 to move in the first direction under guidance of the guide groove A.

As mentioned previously, the pipe 12 passes through the sealing support member 42 and the base 21 in the first direction; therefore, the pipe 12 cannot move in the second direction and has a freedom degree of movement only in the first direction. In this embodiment, the power component 23 drives the guide seat 221 to move along the second direction. Correspondingly, the rolling element 222 moves along the guide groove A to cause displacement in the first direction, thereby driving the valve plate piping 10 to change its position in the first direction.

Furthermore, the drive mechanism 20 includes a guide mechanism 24. The guide mechanism 24 is disposed between the base 21 and the direction-switching limit mechanism 22 and extends in the second direction, so as to guide the direction-switching limit mechanism 22 in the second direction.

In this embodiment, the direction-switching limit mechanism 22 is movably connected to the base 21 through the guide mechanism 24. Specifically, the guide seat 221 is movably connected to the base 21 through the guide mechanism 24, enabling the guide seat 221 to have a freedom degree of movement in the second direction.

It should be understood that the guide mechanism 24 is a linear transmission mechanism. In specific applications, the guide mechanism 24 is a slide block and guide rail transmission mechanism, which is not limited thereto. For example, the guide mechanism 24 can be a gear and rack drive mechanism or a lead screw drive mechanism. The power component 23 can be a motor, which is not limited thereto. For example, the power component 23 can be an electric actuator.

Furthermore, the guide groove A includes a plurality of horizontal groove sections A1 and a plurality of inclined groove sections A2. The horizontal groove sections A1 extend in the second direction. Each inclined groove section A2 connects two adjacent horizontal groove sections A1, and two adjacent horizontal groove sections A1 are spaced apart from each other in the first direction.

The power component 23 is configured to drive the guide seat 221 to move in the second direction, so that the rolling element 222 switches between the plurality of horizontal groove sections A1 under guidance of the corresponding inclined groove section A2.

In this embodiment, the guide groove A is formed by connecting a plurality of horizontal groove sections A1 and a plurality of inclined groove sections A2, and a cross-sectional shape of the guide groove A is step-like. The plurality of horizontal groove sections A1 are spaced apart from each other in the first direction and each extend in the second direction. Two adjacent horizontal groove sections A1 are connected by an inclined groove section A2. Therefore, when moving along the guide groove A, the rolling element 222 does not drive the valve plate piping 10 to move in the first direction when the rolling element 222 is in the horizontal groove section A1, and the rolling element 222 drives the valve plate piping 10 to move in the first direction when the rolling element 222 passes through the inclined groove section A2.

It can be seen that each horizontal groove section A1 can has a limiting function. When the rolling element 222 is located in different horizontal groove sections A1, the valve plate piping 10 is located at different positions in the first direction. In other words, switching between different gear positions is carried out by the cooperation between the rolling element 222 and the guide groove A, and the valve plate piping 10 is located at different positions in the first direction under different operation positions.

Furthermore, the plurality of horizontal groove sections A1 include a first horizontal groove section A11, a second horizontal groove section A12, and a third horizontal groove section A13 that are sequentially spaced apart from each other in the first direction from top to bottom.

When the rolling element 222 is located in the first horizontal groove section A11, the valve plate 11 and the stage 30 are at a first position in the first direction. When the rolling element 222 is located in the second horizontal groove section A12, the valve plate 11 and the stage 30 are at a second position in the first direction. When the rolling element 222 is located in the third horizontal groove section A13, the valve plate 11 and the stage 30 are at a third position in the first direction.

In this embodiment, the number of horizontal groove sections A1 is three, i.e., the direction-switching limit mechanism 22 has three operation positions. When in the first horizontal groove section A11, the rolling element 222 is at a high position. At this time, the valve plate 11 and the stage 30 are at the first position in the first direction, the valve plate 11 isolates the first chamber R1 from the second chamber R2, and the stage 30 is located in the first chamber R1. When in the third horizontal groove section A13, the rolling element 222 is at a low position. At this time, the valve plate 11 and the stage 30 are at the third position in the first direction, and both the valve plate 11 and the stage 30 are located in the second chamber R2. When in the second horizontal groove section A12, the rolling element 222 is at a middle position. At this time, the valve plate 11 and the stage 30 are at the second position in the first direction and are in the second chamber R2, and the second position is located between the first position and the third position.

It should be noted that when the rolling element 222 is at each of the middle position and the low position, the valve plate 11 opens the passage, thereby communicating the first chamber R1 with the second chamber R2. Additionally, the first position is an upper limit position that the valve plate 11 can reach in the first direction, and the third position is a lower limit position that the valve plate 11 can reach in the first direction.

It should be understood that the number of the operation positions of the direction-switching limit mechanism 22 is not limited to three. The number of operation positions of the direction-switching limit mechanism 22 can be adjusted by increasing or decreasing the number of the horizontal groove sections A1 and inclined groove sections A2.

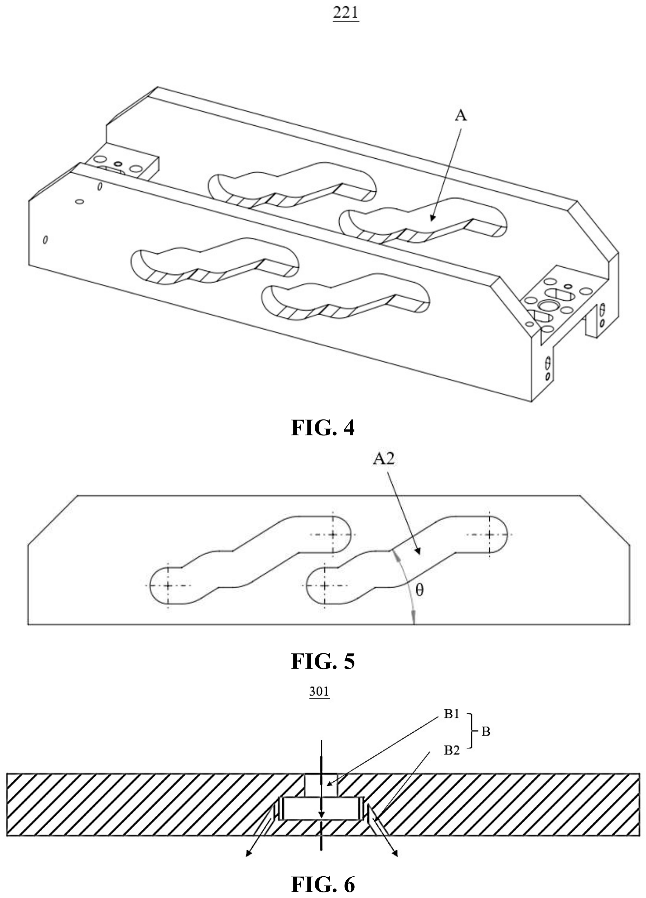

FIG. 4 is a schematic diagram of a guide seat 221 according to an embodiment of the present disclosure. The guide seat 221 is provided with four guide grooves A. Two guide grooves A are provided on each of a front side wall and a rear side wall of the guide seat 221 opposite to each other. Two guide grooves A on a same side wall are parallel to each other. Correspondingly, a plurality of rolling elements 222 are provided to respectively adapt to the guide grooves A. Thus, during the driving process of the power component 23, the plurality of rolling elements 222 operate synchronously to ensure the stability of the vertical movement of the valve plate piping 10. The structural form of the guide seat 221 is not limited to the illustrated embodiment. In specific applications, the rolling element 222 can be a roller. Of course, the rolling element 222 is not limited thereto, for example, the rolling element 222 can be a roller shaft.

It should be understood that an angle between the inclined groove section A2 and the horizontal groove section A1 is one of important factors that determine a magnitude of a driving force required from the power component 23. FIG. 5 is a schematic diagram of the guide seat 221 shown in FIG. 4 from another viewing angle. Referring to FIG. 5, in some optional embodiments, an acute angle between the inclined groove section A2 and the horizontal groove section A1 is θ. If θ is too large, the driving force required from the power component 23 will be relatively large to ensure the movement of the rolling element 222, and it would be difficult to prevent the rolling element 222 from sliding down in case of stalling. If θ is too small, it would lead to a large occupied size of the guide groove A. Thus, preferably, 5° ≤ θ ≤ 30°.

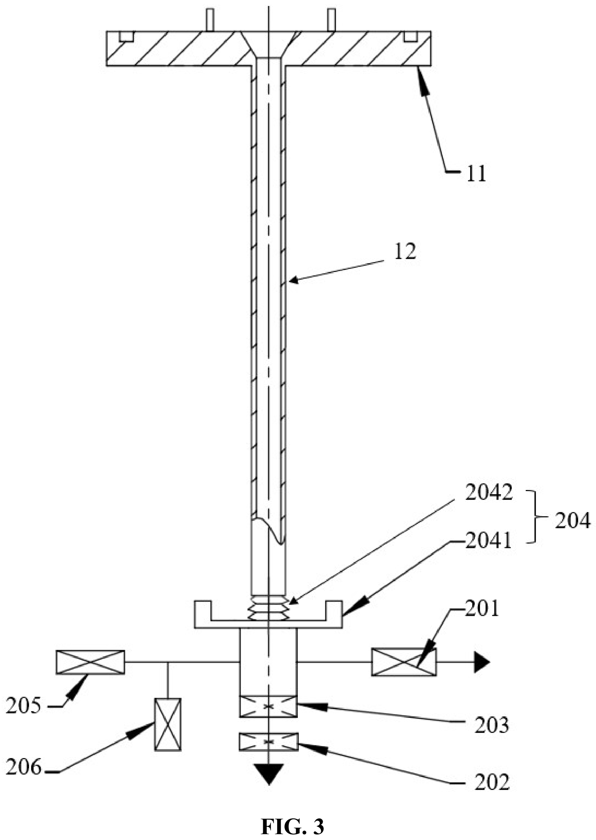

FIG. 3 is a schematic diagram of the cooperation between a vacuum pumping module 200 and a valve plate piping 10 shown in FIG. 1. Referring to FIGS. 1 and 3, in some optional embodiments, the semiconductor inspection device includes a vacuum pumping module 200 and a pressure relief module 300. The vacuum pumping module 200 is disposed at a side of the drive mechanism 20 away from the second chamber R2 in the first direction, is connected to the pipe 12, and is configured to evacuate the first chamber R1 through the pipe 12.

The pressure relief module 300 is connected to the first chamber R1, is located at a side of the first chamber R1 away from the second chamber R2 in the first direction, and is configured to depressurize the first chamber R1.

It should be understood that the pipe 12 is a hollow pipe to allow fluid to pass through. As mentioned previously, the pipe 12 is in communication with the first chamber R1; therefore, the vacuum pumping module 200 can evacuate the first chamber R1 through the pipe 12. After the first chamber R1 is in a vacuum state, when it is necessary to increase the pressure inside the first chamber R1, the pressure relief module 300 can be used for depressurization to break the vacuum.

It should be noted that the silicon wafer 600 on the atmospheric side needs to be transferred into the second chamber R2 through the first chamber R1, and the first chamber R1 needs to be frequently communicated with the atmosphere. In this embodiment, the vacuum pumping module 200 is located below the first chamber R1 and the second chamber R2. During the evacuation process, an airflow direction is always downward, ensuring that the chamber in the first chamber R1 can be carried downward with the airflow and will not deposit on the surface of the silicon wafer 600, meeting the cleanliness requirements of the process.

In some optional embodiments, the vacuum pumping module 200 includes a first pump 201, a second pump 202, a first valve 203, and a transition piping assembly 204. The transition piping assembly 204 is connected to the pipe 12. Both the first pump 201 and the second pump 202 are connected to the transition piping assembly 204 and configured to evacuate the first chamber R1. The first valve 203 is connected to the transition piping assembly 204, is located upstream of the second pump 202, and is configured to control the second pump 202 to operate. The first pump 201 is located upstream of the first valve 203.

In this embodiment, the first pump 201, the second pump 202, and the first valve 203 are all connected to the pipe 12 through the transition piping assembly 204. The first chamber R1 is evacuated in two phases by the first pump 201 and the second pump 202. The first valve 203 is configured to open and close the connection between the second pump 202 and the pipe 12, thereby controlling the second pump 202 to operate.

In some optional embodiments, the semiconductor inspection device includes a handling tool 400. At least a portion of the handling tool 400 is disposed in the second chamber R2 to handle a sample located on the stage 30. Specifically, after entering the second chamber R2 together with the stage 30, the silicon wafer 600 can be handled by the handling tool 400. In specific applications, the handling tool 400 can be a handling robot arm or a rotary arm.

In some optional embodiments, the semiconductor inspection device includes a second valve 500. The second valve 500 is connected to the first chamber R1 and is configured to open and close the first chamber R1. Specifically, the silicon wafer 600 on the atmosphere side can enter the first chamber R1 through the second valve 500.

To facilitate the description of this embodiment, the transfer process of the silicon wafer 600 is described below in conjunction with FIG. 1. In the embodiment shown in FIG. 1, the second valve 500 seals the first chamber R1 and the valve plate 11 separates the first chamber R1 and the second chamber R2. In this case, the direction-switching limit mechanism 22 is at the high position, both the valve plate 11 and the stage 30 are at the first position, and the stage 30 is located in the first chamber R1.

When the first chamber R1 is in a vacuum state, the pressure relief module 300 can be controlled to release gas into the first chamber R1 to increase the pressure until the pressure inside the first chamber R1 satisfies an opening condition of the second valve 500. Then, the pressure relief module 300 is closed and the second valve 500 is opened, a handling robot located outside the first chamber R1 takes out the inspected silicon wafer 600 from the stage 30, places a silicon wafer 600 to be inspected on the stage 30, and then closes the second valve 500.

The first pump 201 is turned on to perform a first phase of evacuation on the first chamber R1 until the pressure in the first chamber R1 reaches a first-phase preset pressure during the first phase, then the first pump 201 is turned off and the first valve 203 is opened, and the second pump 202 is turned on to perform a second-phase of evacuation on the first chamber R1 until the pressure in the first chamber R1 reaches a second-phase preset pressure, ensuring that a vacuum level of the first chamber R1 satisfies the requirement. The power component 23 is turned on to switch the operation positions of the direction-switching limit mechanism 22.

When the direction-switching limit mechanism 22 is at the middle position or the low position, both the valve plate 11 and the stage 30 are located in the second chamber R2. Correspondingly, the silicon wafer 600 is also located in the second chamber R2. In this case, the handling tool 400 can be controlled to transfer the silicon wafer 600 to the downstream process. In specific applications, the first pump 201 is a dry pump, and the second pump 202 is a molecular pump.

FIG. 6 is a cross-sectional view of the cover plate 301 in FIG. 1. Referring to FIGS. 1 and 6, in some optional embodiments, the pressure relief module 300 includes a cover plate 301 and a pressure relief valve 302. The cover plate 301 covers the first chamber R1 and is provided with an air passage B penetrating through the cover plate 301.

The air passage B includes a main air passage section B1 and a plurality of branch air passage sections B2. The pressure relief valve 302 is in communication with the main air passage section B1. The main air passage section B1 extends in the first direction. Each of the branch air passage sections B2 is connected to the main air passage section B1 and the first chamber R1. The branch air passage sections B2 are symmetrical about a center of the main air passage section B1.

In this embodiment, the first chamber R1 can communicate with the external atmosphere through the pressure relief valve 302 and the air passage B. The air passage B is formed by the main air passage section B1 and the plurality of branch air passage sections B2. The air introduced through the main air passage section B1 is divided by the branch air passage sections B2 to reduce the air pressure. Projections of the plurality of branch air passage sections B2 in the vertical direction are radial, centered on the main air passage section B1, which can prevent the introduced airflow from directly impacting the silicon wafer 600 downward, prevent the silicon wafer 600 from breaking, and reduce the risk of blowing the silicon wafer 600.

Furthermore, the cover plate 301 can be made of a transparent material such as an acrylic plate or high-pressure resistant glass. In this way, the status of the silicon wafer 600 located in the first chamber R1 can be observed through the cover plate 301, facilitating timely problem discovery and maintenance.

Referring to FIG. 3, in some optional embodiments, the vacuum pumping module 200 includes a pressure gauge 205 and a vacuum gauge 206. Both the pressure gauge 205 and the vacuum gauge 206 are connected to the transition piping assembly 204. The pressure gauge 205 and the vacuum gauge 206 are provided to monitor whether the pressure in the first chamber R1 satisfies the pressure conditions of the corresponding stages. It should be understood that both the pressure gauge 205 and the vacuum gauge 206 are configured to detect chamber pressure, but the pressure gauge 205 and the vacuum gauge 206 have different range and accuracy. The pressure gauge 205 has a relatively large range and low accuracy, while the vacuum gauge 206 has a relatively small range and high accuracy. These two pressure measurement components enables monitoring the pressure in the first chamber R1 at different phases.

Referring to FIGS. 1 and 3, in some optional embodiments, the transition piping assembly 204 includes a transition piping section 2041 and a second deformable sleeve 2042. The transition piping section 2041 is disposed on the drive mechanism 20. Two ends of the second deformable sleeve 2042 are connected to the pipe 12 and the transition piping section 2041, respectively.

In this embodiment, the pipe 12 passes through the base 21 and is then connected to the second deformable sleeve 2042. During the movement of the valve plate piping 10 in the first direction, the second deformable sleeve 2042 deforms in the first direction to adapt to the positional change of the pipe 12. The first pump 201, the second pump 202, and the first valve 203 are all connected to the transition piping section 2041. The transition piping section 2041 is fixed on the base 21.

In specific applications, the second deformable sleeve 2042 is a bellows, which is not limited thereto. For example, the second deformable sleeve 2042 can be an elastic rubber tube.

It should be noted that, in the aforementioned embodiments, the transfer of the silicon wafer 600 is taken as an example for description, but it is not limited thereto.

Although the embodiments of the present disclosure have been shown and described above, it should be understood that the aforementioned embodiments are exemplary and should not be construed as limitations on the present disclosure. Those skilled in the art can make changes, modifications, alternatives, and variations to the aforementioned embodiments within the scope of the present disclosure.

## Claims

1. A wafer transfer apparatus, comprising:
a valve plate piping comprising a valve plate and a pipe extending from the valve plate in a first direction;
a stage connected to the valve plate; and
a drive mechanism connected to the pipe, the stage being located on a side of the valve plate away from the drive mechanism in the first direction, and the drive mechanism being configured to drive the valve plate piping to move in the first direction to adjust a position of the valve plate and a position of the stage in the first direction.

2. The wafer transfer apparatus according to claim 1, wherein the drive mechanism comprises:
a base through which the pipe passes,
a direction-switching limit mechanism movably connected to the base and the pipe, and
a power component disposed on the base, connected to the direction-switching limit mechanism, and configured to drive the direction-switching limit mechanism to operate in a second direction to adjust a position of the valve plate piping in the first direction, the first direction being perpendicular to the second direction.

3. The wafer transfer apparatus according to claim 2, wherein
the direction-switching limit mechanism comprises:
a guide seat provided with a guide groove and connected to the power component, and
a rolling element connected to the pipe and disposed in the guide groove; and
the power component is configured to drive the guide seat to move in the second direction so that the rolling element moves in the first direction under guidance of the guide groove.

4. The wafer transfer apparatus according to claim 3, wherein
the guide groove comprises:
a plurality of horizontal groove sections each extending in the second direction, and
a plurality of inclined groove sections, each of which connects adjacent two of the plurality of horizontal groove sections, the adjacent two of the plurality of horizontal groove sections being spaced apart from each other in the first direction; and
the power component is configured to drive the guide seat to move in the second direction so that the rolling element switches between the plurality of horizontal groove sections under guidance of a corresponding one of the plurality of inclined groove sections.

5. The wafer transfer apparatus according to claim 4, wherein
the plurality of horizontal groove sections comprises a first horizontal groove section, a second horizontal groove section, and a third horizontal groove section that are sequentially spaced apart from each other in the first direction from top to bottom;
when the rolling element is located in the first horizontal groove section, the valve plate and the stage are at a first position in the first direction;
when the rolling element is located in the second horizontal groove section, the valve plate and the stage are at a second position in the first direction; and
when the rolling element is located in the third horizontal groove section, the valve plate and the stage are at a third position in the first direction.

6. The wafer transfer apparatus according to claim 1, further comprising:
a sealing assembly,
wherein the sealing assembly comprises:
a sealing support member parallel to and spaced apart from the valve plate in the first direction, and located between the valve plate and the drive mechanism, and
a first deformable sleeve having two ends respectively connected to the valve plate and the sealing support member to enclose and define a third chamber together with the valve plate and the sealing support member, the pipe passing through the third chamber and the sealing support member and protruding out of the third chamber.

7. A semiconductor inspection device, comprising:
the wafer transfer apparatus according to any one of claims 1 to 6;
a first chamber; and
a second chamber,
wherein the first chamber is connected to the second chamber in the first direction, and the drive mechanism is located outside the second chamber and is located at a side of the second chamber away from the first chamber in the first direction;
the valve plate is located in the second chamber, the pipe is in communication with the first chamber, and the valve plate is configured to move under an action of the drive mechanism so that the first chamber and the second chamber are in communication with or isolate from each other; and
under a condition that the first chamber and the second chamber are in an isolated state, the stage is located in the first chamber, and under a condition that the first chamber and the second chamber are in a communicated state, the stage is located in the second chamber.

8. The semiconductor inspection device according to claim 7, further comprising:
a vacuum pumping module, which is disposed at a side of the drive mechanism away from the second chamber in the first direction, which is in communication with the pipe, and which is configured to evacuate the first chamber through the pipe; and
a pressure relief module, which is connected to the first chamber, which is located at a side of the first chamber away from the second chamber in the first direction, and which is configured to depressurize the first chamber.

9. The semiconductor inspection device according to claim 8, wherein
the pressure relief module comprises a pressure relief valve, and a cover plate covering the first chamber and provided with an air passage penetrating through the cover plate; and
the air passage comprises:
a main air passage section in communication with the pressure relief valve and extending in the first direction, and
a plurality of branch air passage sections arranged symmetrically about a center of the main air passage section and each connected to the main air passage section and the first chamber.

10. The semiconductor inspection device according to claim 8, wherein the vacuum pumping module comprises:
a transition piping assembly connected to the pipe,
a first pump and a second pump each connected to the transition piping assembly and configured to evacuate the first chamber, and
a first valve connected to the transition piping assembly, located upstream of the second pump, and configured to control the second pump to operate, the first pump being located upstream of the first valve.
